# EUROPEAN PATENT APPLICATION

(11) **EP 4 848 337 A1**
(43) Date of publication of application: **02.12.2026**
(21) Application number: 25178776.8
(22) Date of filing: 26.05.2025
(51) Int. Cl.: H01L 23/00

(54) **DONOR SYSTEM**

(71) Applicant: ASML Netherlands B.V., 5500 AH Veldhoven (NL)
(72) Inventor: SEIJGER, Olav, Johannes, 5500 AH Veldhoven (NL); RENKENS, Michael, Jozefa, Mathijs, 5500 AH Veldhoven (NL)
(74) Representative: ASML Netherlands B.V.

(57) **Abstract**

A donor system for a bonding tool, comprising: a donor substrate configured to carry a plurality of dies; and an actuation system configured to sequentially control the plurality of dies, while being carried by the donor substrate, to be closest to an acceptor surface of an acceptor substrate. A bonding system comprising the donor system.

## Description

### TECHNICAL FIELD

The present invention relates to a donor system, a bonding tool, a method for moving dies and a method for bonding.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in a bonding process (e.g., improvements in heterogeneous integration) lead to improvements in IC manufacturing and integration abilities. In a bonding process, dies or substrates are to be transferred from a donor substrate onto a stage or acceptor substrate. In order to pick dies off a donor substrate, a gantry may be used.

The gantry is required to have die clamps for clamping the dies. The die clamps may need to be changed depending on the size of the die, and when they wear out or collect too much debris. Exchanging the die clamps takes time and reduces the overall throughput. The die clamps typically require moving cables and hoses, that can undesirably generate particles. Such particles might fall down on the dies, for example, which can result in failed bonding.

It is desirable to increase the overall throughput and/or reduce the possibility of bonding failing.

### SUMMARY

According to an embodiment, there is provided a donor system for a bonding tool, the donor system comprising:
a donor substrate configured to carry a plurality of dies; and
an actuation system configured to sequentially control the plurality of dies, while being carried by the donor substrate, to be closest to an acceptor surface of an acceptor substrate.

According to an embodiment, there is provided a method for moving dies relative to an acceptor substrate within a bonding tool, the method comprising:
carrying a plurality of dies with a donor substrate; and
actuating the donor substrate so as to sequentially control which of the plurality of dies is closest to an acceptor surface of the acceptor substrate.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 schematically depicts a donor system.
Figure 3 schematically depicts the donor system of Figure 2 carrying donor dies.
Figure 4 is a schematic perspective view of the donor system of Figure 2.
Figure 5 schematically depicts the donor system of Figure 2 in a bonding tool.
Figure 6, Figure 7 and Figure 8 schematically depict the donor system of Figure 2 at different stages of use in the bonding tool.
Figure 9 schematically depicts an alternative donor system.
Figure 10 and Figure 11 schematically depicts alternative arrangements of dies carried by the donor system.
Figure 12 schematically depicts an alternative use of the donor system in a bonding tool.
Figure 13 schematically depicts a pressure system of the donor system.
Figure 14 schematically depicts a cross-sectional view of the pressure system of Figure 13.
Figure 15 is a perspective view of one part of the pressure system of Figure 14.
Figure 16 is another view of the part shown in Figure 15.
Figure 17 schematically depicts an alternative donor system.
Figure 18 schematically depicts an alternative donor system.
Figure 19 schematically depicts an alternative donor system.
Figure 20 schematically depicts a close-up view of part of the donor system shown in Figure 19.
Figure 21 schematically depicts the part shown in Figure 20 in a different configuration.
Figure 22 schematically depicts use of the donor system of Figure 19 in a bonding tool.
Figure 23 and Figure 24 schematically depict use of the donor system of Figure 19 at different stages in a bonding tool.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

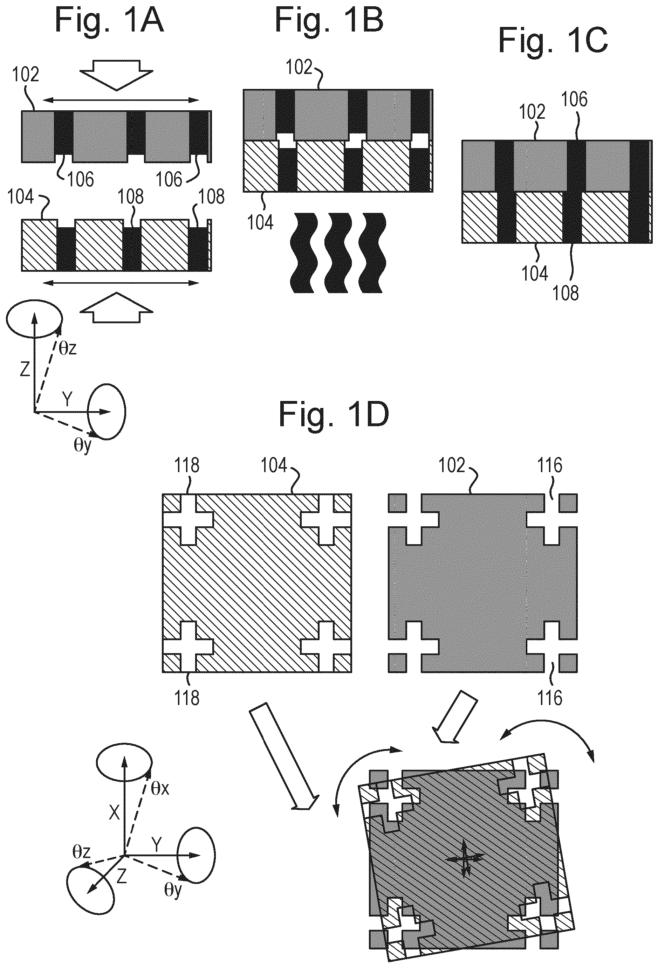

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

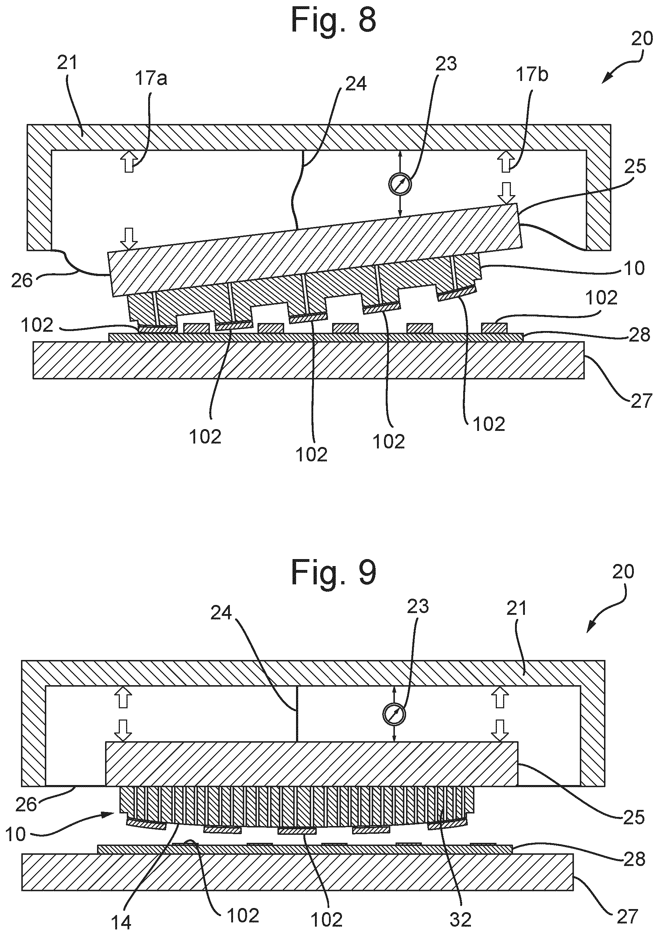

In Figure 1, a single donor die 102 is shown being bonded to a single target die 104. In an embodiment a plurality of donor dies 102 are bonded to a respective plurality of target dies 104. It is not essential for there to be a one-to-one correspondence between donor dies 102 and target dies 104. For example, in an embodiment a plurality of donor dies 102 are bonded to an acceptor substrate 28 (e.g. see Figure 8). Such an acceptor substrate 28 may be substantially similar to a target die 104 except that the acceptor substrate 28 bonds to a plurality of donor dies 102, instead of to only one donor die 102.

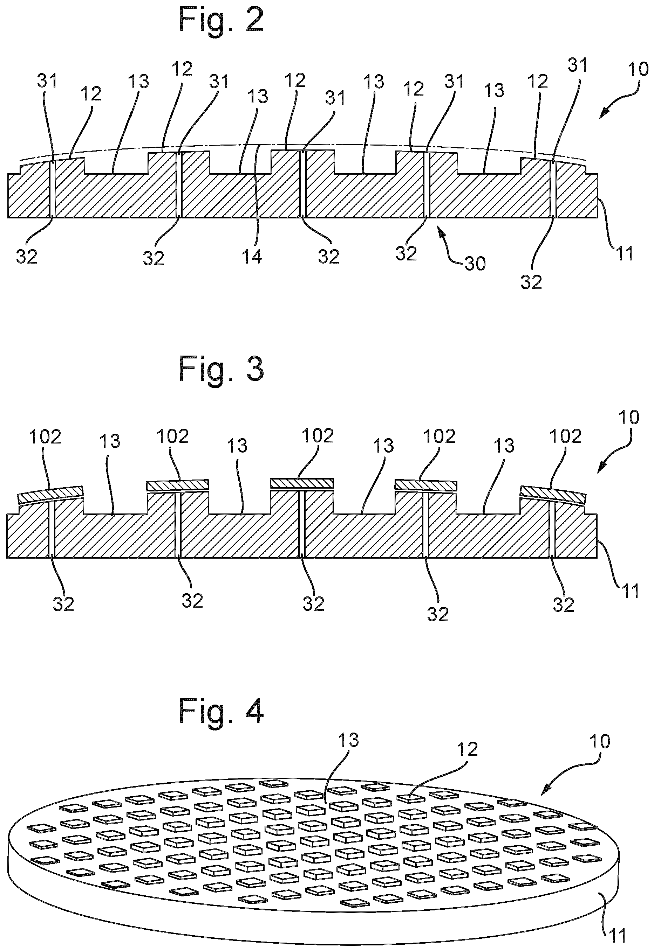

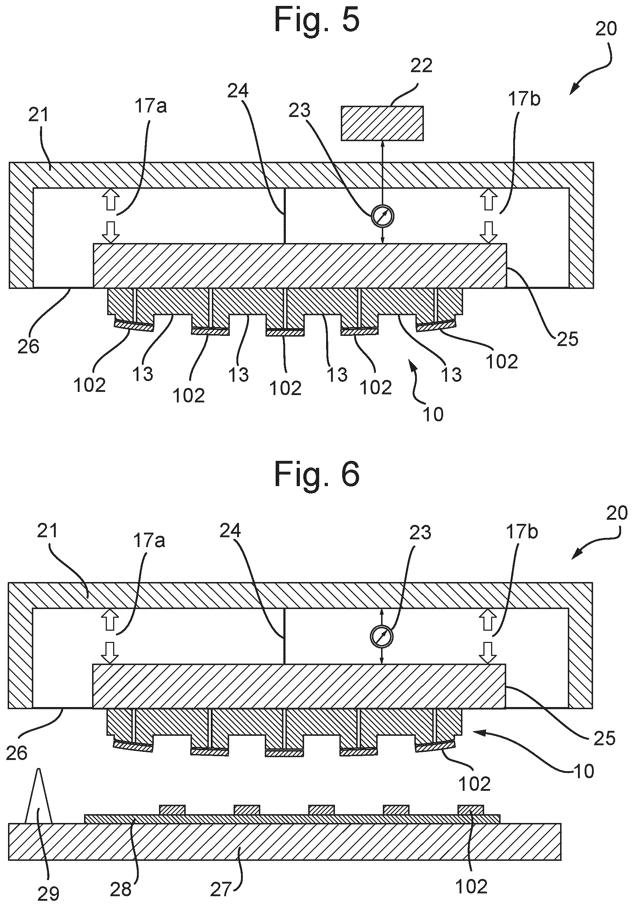

Figure 2 schematically depicts a donor system 10. The donor system 10 is for a bonding tool 20 (e.g. see Figure 5). At least part of the donor system 10 is configured to be transferable into and out from the bonding tool 20. In an embodiment the donor system 10 is configured such that donor dies 102 can be placed onto the donor system 10 or onto part of the donor system 10 while the donor system 10 is outside of the bonding tool 20. At least part of the donor system 10 is transferable into the bonding tool 20 with the donor dies 102 carried by the donor system 10. In an embodiment the bonding tool 20 is configured to perform a bonding process. For example, the bonding tool 20 may be configured to bond the donor dies 102 to respective target dies 104 or to an acceptor substrate 28.

In an embodiment the donor system 10 is configured to carry a plurality of donor dies 102. Figure 3 schematically depicts the donor system 10 of Figure 2 carrying a plurality of donor dies 102. Figure 2 schematically depicts part of the donor system 10. In Figure 2 and Figure 3, the donor system 10 is shown for carrying five donor dies 102, merely for convenience of explanation. In an embodiment the donor system 10 is configured to carry at least 10, optionally at least 20, optionally at least 50, optionally at least 100 and optionally at least 200 donor dies 102.

Figure 2 is a cross-sectional view of the donor system 10. Figure 4 schematically depicts a perspective view of the donor system 10. As shown in Figure 4, in an embodiment the donor system 10 is configured to carry a plurality of donor dies 102 in a pattern. The pattern may be a two-dimensional pattern. For example, the donor system 10 may be configured to carry a plurality of donor dies 102 arranged in a grid formation. Other arrangements of donor dies 102 on the donor system 10 are possible.

As shown in Figure 2, in an embodiment the donor system 10 comprises a donor substrate 11. The donor substrate 11 is configured to carry the plurality of dies 102. In an embodiment the donor substrate 11 is transferable into and out from the bonding tool 20. For example, the donor dies 102 may be mounted onto the donor substrate 11 when the donor substrate 11 is outside the bonding tool 20. A handler may be configured to transfer the donor substrate 11 with the dies 102 loaded on it into the bonding tool 20.

As shown in Figure 2, in an embodiment the donor substrate 11 is generally plate shaped. For example, the donor substrate 11 may be substantially planar. The donor substrate 11 may have a slight curve.

Figure 2 schematically shows the donor substrate 11 without the dies 102 loaded onto it. Figure 3 schematically depicts the donor substrate 11 with the donor dies 102 loaded onto it. Figure 4 is a perspective view of donor substrate 11.

Figure 5 schematically depicts a bonding tool 20 comprising the donor system 10. As shown in Figure 5, in an embodiment the donor system 10 comprises an actuation system 17. The actuation system 17 is configured to sequentially control the plurality of dies 102 to be closest to an acceptor surface of an acceptor substrate 28. The actuation system 17 is configured to actuate the donor substrate 11. By actuating the donor substrate 11, the donor dies 102 can be actuated to positions in which the donor dies 102 are ready for bonding to the acceptor substrate 28. In an embodiment the donor dies 102 are to be bonded sequentially. The actuation system 17 is configured to sequentially position each of the donor dies 102 in a position in which that donor dies 102 is ready to be bonded to the acceptor substrate 28.

In an embodiment the donor dies 102 are transferred directly from the donor substrate 11 to the acceptor substrate 28 for bonding. It is not necessary to provide any intermediate step of removing the donor dies 102 from the donor substrate 11 and subsequently transferring the donor dies 102 onto the acceptor substrate 28. As such, it is not necessary to provide an additional pick and place element to transfer the donor dies 102 from the donor substrate 11 to the acceptor substrate 28. An embodiment of the invention is expected to simplify the bonding tool 20. An embodiment of the invention is expected to reduce the cost of manufacturing the bonding tool 20.

By avoiding the need for an additional pick and place element, the disadvantages of requiring the additional dies clamps for holding the donor dies 102 with the pick and place element are avoided. For example, over time the dies clamps will wear out and collect debris. The dies clamps need to be exchanged on a frequent basis, reducing throughput. The wearing out and collection of debris reduce the reliability of the dies clamps. An embodiment of the invention is expected to increase throughput of a bonding process. An embodiment of the invention is expected to improve reliability of bonding.

By reducing the number of machines required to perform the bonding process, the number of moving cables and hoses may be reduced. For example, it may not be necessary to provide the moving cables and hoses that may be required to power dies clamps of an additional pick and place element between the donor substrate 11 and the acceptor substrate 28. By reducing the presence of moving cables and hoses, a possibility of particles (i.e. dust) being undesirably generated may be reduced. Such particles are undesirable, for example because the particles may contact a surface of the donor dies 102 and/or the surface of the acceptor substrate 28 or target dies 104. Such particles can cause defects in the bonding process. An embodiment of the invention is expected to improve the accuracy of bonding. An embodiment of the invention is expected to increase yield in a bonding process. An embodiment of the invention is expected to reduce the amount of time for which the bonding tool 20 cannot be used for maintenance reasons.

As shown in Figure 5, in an embodiment the bonding tool 20 comprises a base frame 21. The base frame 21 may be configured to provide mechanical support for one or more components of the bonding tool 20. In an embodiment the base frame 21 is configured to provide mechanical support for the donor system 10. As shown in Figure 5, in an embodiment the base frame 21 of the bonding tool 20 is configured to mechanically support the donor system 10. The donor system 10 may be attached to the base frame 21.

As shown in Figure 5, in an embodiment the actuation system 17 is mounted to the base frame 21. As shown in Figure 5, in an embodiment the donor system 10 comprises a stage 25. In an embodiment the actuation system 17 is configured to actuate the donor substrate 11 via the stage 25. The stage 25 may alternatively be considered to form part of the actuation system 17.

In an embodiment the donor substrate 11 is detachably connected to the stage 25. For example, the stage 25 and/or the donor substrate 11 may comprise an interface for coupling the stage 25 to the donor substrate 11. When the donor substrate 11 is detached from the stage 25, then the donor substrate 11 may be located outside the bonding tool 20. The donor dies 102 may be loaded onto the donor substrate 11. The handler is configured to transfer the donor substrate 11 onto the stage 25 in the bonding tool 20. In an embodiment the stage 25 remains connected to the base frame 21 of the bonding tool 20 while the donor substrate 11 is transferred into and/or from the bonding tool 20.

As shown in Figure 5, in an embodiment the stage 25 is connected to the base frame 21 of the bonding tool 20 via a membrane 26. In an embodiment the membrane 26 is elastic. During actuation of the donor substrate 11, the membrane 26 is configured to elastically deform. The membrane 26 is configured to maintain connection between the stage 25 and the base frame 21, without interfering with actuation of the donor substrate 11 by the actuation system 17. In an embodiment the membrane 26 is compliant with respect to movement of the donor substrate 11.

As shown in Figure 5, in an embodiment the stage 25 is coupled to the base frame 21 via a coupling 24. In an embodiment the coupling 24 comprises a longitudinal element such as a rod. In an embodiment the coupling 24 is substantially elastic. The coupling 24 is configured to maintain connection between the stage 25 and the base frame 21 without interfering with the actuation of the stage 25 by the actuation system 17. For example, the coupling 24 may be compliant for rotation about the vertical axis. In an embodiment the coupling 24 remains substantially vertical during use of the donor system 10.

As shown in Figure 5, in an embodiment the bonding tool 20 comprises a metrology frame 22. The metrology frame 22 may be separate from the base frame 21. In an alternative embodiment, the base frame 21 may function as a metrology frame 22.

In an embodiment the metrology frame 22 provides a reference for measurements of the donor system 10 and/or the donor dies 102, for example. For example, location of the donor substrate 11 and/or one or more of the donor dies 102 may be measured relative to the metrology frame 22. As shown in Figure 2, for example, in an embodiment the donor substrate 11 is configured to carry the dies 102 on a non-planar surface 14. For example, the donor substrate 11 may be configured to carry the dies 102 on the non-planer surface 14 such that different dies 102 are differently distanced from the acceptor surface of the acceptor substrate 28. The acceptor substrate 228 may be planar. In an embodiment the donor substrate 11 is located such that the non-planar surface 14 of the donor substrate 11 faces the acceptor substrate 28. For example, in the arrangement shown in Figure 5, the acceptor substrate 28 (not shown) may be located directly below the donor system 10. Alternatively, in the arrangement shown in Figure 2, the acceptor substrate 28 may be located directly above the donor substrate 11, with the acceptor surface facing downwards towards the donor substrate 11. Figure 2 schematically depicts a curvature of the non-planar surface 14. In an embodiment the non-planar surface 14 is curved. However, it is not essential for the non-planar surface 14 to be curved. For example, in an alternatively embodiment the non-planar surface 14 may comprise a plurality of non-parallel planar regions. The planar regions may be arranged so as to approximate a curved surface, for example. This may be analogous to the arrangement of a Fresnel lens.

As shown in Figure 2, in an embodiment the non-planar surface 14 is a substantially spherical sector. The non-planar surface 14 may have a radius of curvature. In an embodiment the radius of curvature of the non-planar surface 14 is at least 0.1m, optionally at least 0.2m, optionally at least 0.5m, optionally at least 1m, optionally at least 2m, optionally at least 5m, and optionally at least 10m. By increasing the radius of curvature, a greater number of dies 102 may be located on the donor substrate 11. By increasing the radius of curvature, the extent by which the donor substrate 11 is required to be actuated during a bonding process may be reduced.

In an embodiment the radius of curvature is at most 200m, optionally at most 100m, optionally at most 50m, optionally at most 220m, optionally at most 10m, optionally at most 5m, and optionally at most 2m. By reducing the radius of curvature, the possibility of dies adjacent to the donor dies 102 that is bonded undesirably contacting the acceptor substrate 28 (or other dies located on the acceptor substrate 28) may be reduced. An embodiment of the invention is expected to improve reliability of the bonding process.

It is not essential for the non-planar surface 14 to be substantially spherical sector. In an alternative embodiment the non-planar surface 14 comprises an aspherical surface. The shape of the non-planar surface 14 may be selected so as to optimise the bonding process. For example, the shape of the non-planar surface 14 may be selected so as to reduce the extent by which the donor substrate 11 is required to be actuated during a bonding process, or to reduce the possibility of dies adjacent to the donor dies 102 that is bonded undesirably contacting the acceptor substrate (or other dies located on the acceptor substrate 28).

In an embodiment the actuation system 17 is configured to rotate the donor substrate 11 about at least 1 axis perpendicular to the bonding direction, or parallel to the acceptor surface. For example, motions of the donor substrate 11 may be described with reference to a coordinates system in which the vertical direction shown in Figure 5 is the bonding direction, along which the donor substrate and/or the acceptor substrate is moved relative to each other for bonding the die with the acceptor substrate, the left-right direction corresponds to the X axis and the direction into and out of the page corresponds to the Y axis. In an embodiment the actuation system 17 is configured to rotate the donor substrate 11 about the X axis. For example, the actuation system 17 may comprise a first actuator 17a configured to rotate the donor substrate 11 about the X axis. In an embodiment the first actuator 17a is configured to actuate the stage 25 to which the donor substrate 11 is attached. The first actuator 17a is configured to actuate the stage 25 relative to the base frame 21 of the bonding tool 20.

In an embodiment the actuation system 17 is configured to rotate the donor substrate 11 about two non-parallel axes perpendicular to the bonding direction, or parallel to the acceptor surface. For example, in an embodiment the actuation system 17 is configured to rotate the donor substrate 11 about the Y axis. The actuation system 17 may comprise a second actuator 17b. the second actuator 17b is configured to actuate the donor substrate 11 about the Y axis. In an embodiment the second actuator 17b is configured to actuate the stage 25 relative to the base frame 21. By actuating the stage 25, the second actuator 17b is configured to actuate the donor substrate 11 about the Y axis. In an embodiment, the X axis and the Y axis are substantially perpendicular to the bonding direction. In an embodiment the X axis and the Y axis are substantially parallel to the acceptor surface of the acceptor substrate 28.

It is not essential for the actuation system 17 to rotate the donor substrate 11 about two non-parallel axes. For example, in an alternative embodiment the actuation system 17 is configured to rotate the donor substrate 11 about only one axis perpendicular to the bonding direction, or parallel to the acceptor surface. For example, in the arrangement shown in Figure 5, the first actuator 17a may be omitted. The second actuator 17b may rotate the donor substrate 11 about the Y axis so as control which of the donor dies 102 is closest to the acceptor surface. At the point in time shown in Figure 5, the central dies out of the five donors dies 102 shown is closest to the acceptor surface (i.e. furthest down in Figure 5). By rotating the donor substrate 11 about the Y axis, different donor dies 102 shown in Figure 5 may be located furthest down, i.e. closest to the acceptor substrate 28.

By providing that the actuation system is configured to rotate the donor substrate 11 about two non-parallel axes, a greater number of dies 102 mounted on the donor substrate 11 may be controlled to be closest to the acceptor substrate 28 (i.e. ready for bonding). The donor substrate 11 may carry a two-dimensional array of donor dies 102 for bonding. In an embodiment, the two non-parallel axes are substantially orthogonal to each other. Alternatively, the two non- parallel axes may be angled obliquely to each other.

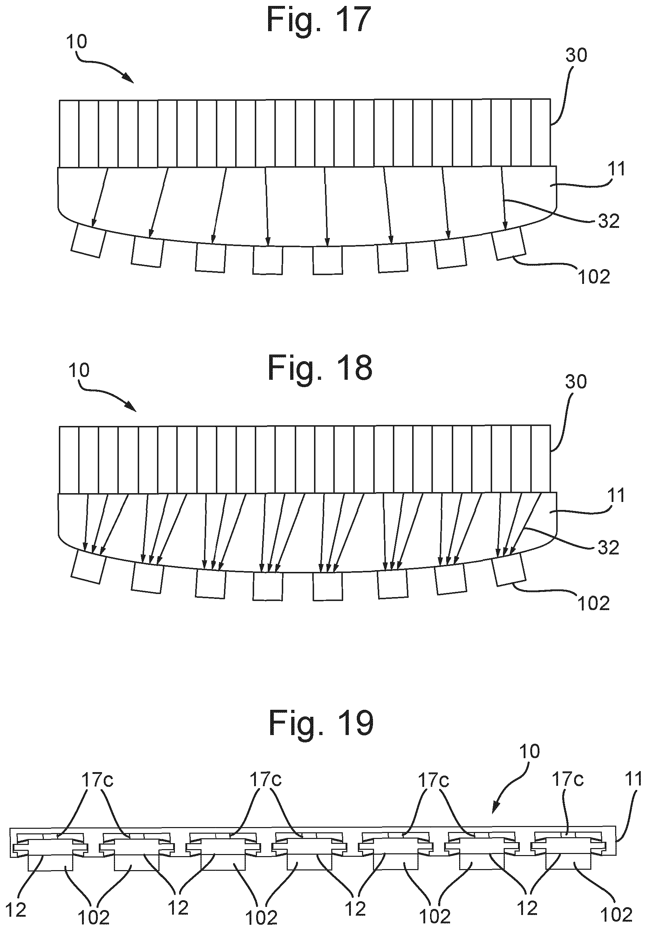

It is not essential for the actuation system 17 to rotate the donor substrate 11 about any axis perpendicular to the bonding direction, or parallel to the acceptor surface of the acceptor substrate 28. For example, an alternative embodiment is described with reference to Figure 19.

As shown in Figure 2, in an embodiment the donor substrate 11 is configured to carry the dies 102 at respective carrier surfaces 12 of the donor substrate 11. The carrier surfaces 12 may form part of the non-planar surface 14. For example, when the non-planar surface 14 is a substantially spherical section, then the individual carrier surfaces 12 are smaller spherical sectors. As shown in Figure 2, in an embodiment the carrier surfaces 12 are convex. By providing that the carrier surfaces 12 are convex, the donor dies 102 supported at the carrier surfaces 12 may have a non-planar shape. For example, the donor dies 102 may form convex shapes facing towards the acceptor substrate 28. When the donor dies 102 are brought into contact with the acceptor substrate 28, it may be the central portion of the donor dies 102 that first makes contact with the acceptor substrate 28. An embodiment of the invention is expected to facilitate bonding between the donor dies 102 and the acceptor substrate 28. When the donor dies 102 bonds to the acceptor substrate 28, the bond front propagates outwards from the central portion of the donor dies 102 where contact is first made with the acceptor substrate 28.

However, it is not essential for the carrier surfaces 12 to be convex. In an alternative embodiment the carrier surfaces 12 are substantially planar.

As shown in Figure 5, in an embodiment the bonding tool 20 comprises a measurement system 23. The measurement system 23 may be configured to measure the location of the stage 25 (and hence the donor substrate 11) relative to the metrology frame 22 of the bonding tool 20. In an embodiment the measurement system 23 is configured to output data indicative of the position of the donor substrate 11 to a controller that controls the actuation system 17. In an embodiment the measurement system 23 is configured to provide feedback for the actuation system 17.

Figure 6 schematically depicts the donor system 10 with dies 102 facing the acceptor substrate 28. In the arrangement shown in Figure 6, the measurement system 23 is shown measuring the position of the stage 25 relative to the base frame 21. In an embodiment the measurement system 23 measures the stage position relative to the metrology frame 22 (not shown in Figure 6, for convenience).

As shown in Figure 6, in an embodiment the bonding tool 20 comprises a sensor system 29. The sensor system 29 may comprise an alignment sensor configured to measure alignment of one or more donor dies 102 relative to the acceptor substrate 28. In an embodiment the sensor system 29 comprises a level sensor configured to measure topography or flatness of or distance to one or more dies 102 on the donor substrate 11 of the donor system 10. The sensor system 29 is configured to measure positions of the dies 102 carrier by the donor substrate 11 relative to the acceptor surface of the acceptor substrate 28.

In an embodiment the sensor system 29 is configured to measure the positions of the dies 102 to an accuracy greater than the accuracy with which the positions of the dies 102 may be controlled by the actuation system 17.

As shown in Figure 6, in an embodiment the bonding tool 20 comprises an acceptor stage 27. The acceptor stage 27 may be referred to as a short stroke stage. That is, the acceptor stage 27 may be configured to position the acceptor substrate 28 to a particularly high level of accuracy. The acceptor stage 27 is configured to position the acceptor substrate relative to a frame (e.g. the base frame 21 and/or the metrology frame 22) of the bonding tool 20. In an embodiment the acceptor stage 27 is configured to position the acceptor substrate 28 in at least 2, optionally at least 4, optionally at least 5 and optionally at least 6 degrees of freedom.

As shown in Figure 6, in an embodiment the sensor system 29 is mounted on the acceptor stage 27. The sensor system 29 may remain substantially stationary on the acceptor stage 27.

In an embodiment a method of using the donor system 10 comprises calibrating the sensor system 29. For example, the position of the alignment sensor and height of the level sensor may be calibrated.

In an embodiment the sensor system 29 is configured to measure marks on the donor dies 102. For example, the donor dies 102 may comprise fiducial marks so as to allow their position to be measured more accurately and/or more reliably.

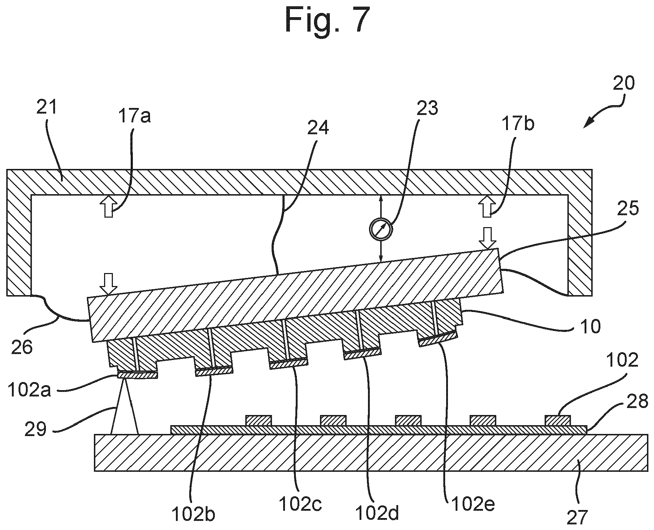

Figure 7 schematically depicts the arrangement shown in Figure 6, but with the donor substrate 11 actuated such that the left-hand most donor die 102a is located to have its position measured by the sensor system 29. Before a mark on the first donor die 102a is measured, the actuation system 17 is configured to move the stage 25 towards an orientation at which the first donor die 102a is substantially level. Here, substantially level means that the first donor die 102a has approximately a zero-tilt relative to the X axis and the Y axis. This is shown in Figure 7 where the first donor die 102a is shown to be flat. Meanwhile, the other dies to the right of the first donor die 102a are tilted as a result of the non-planar surface of the donor substrate 11.

When the first die 102a is later bonded to the acceptor substrate 28, the first die 102a will be in the level orientation shown in Figure 7. In other words, the first die 102a is measured in an orientation in which the first die 102a will later be bonded.

In an embodiment the sensor system 29 is configured to accurately measure the location of the first die 102a. As mentioned above, in an embodiment the measurement system 23 is configured to accurately measure the position of the stage 25 relative to the metrology frame 22. The location of the first donor die 102 may be known with respect to the metrology frame 22 and the acceptor stage 27.

Figure 7 schematically shows the elastic flexing of the membrane 26 and the coupling 24 when the stage 25 is actuated by the actuated system 17.

In an embodiment the method comprises measuring positions of a set of the dies 102 carried by the donor substrate 11 relative to the acceptor surface of the acceptor substrate 28. For example, a plurality, and optionally all, of the donor dies 102 have their position measured by the sensor system 29. In the arrangement shown in Figure 7, the five donor dies 102a, 102b, 102c, 102d, 102e may have their positions measured sequentially. In an embodiment the actuation system 17 is configured to actuate the donor substrate 11 such that the second donor die 102b has a substantially level orientation. The donor substrate 11 is actuated sequentially such that each donor die 102 has a substantially level orientation at which point it has its position measured by the sensor system 29.

In an embodiment the sensor system 29 is located directly below the die 102 to be measured. For example, in Figure 7 the sensor system 29 is located directly below the first donor die 102a. As the other dies 102 have their position measured, the acceptor stage 27 may be moved so as to move the sensor system 29 such that it can measure the position of the subsequent dies 102. In an embodiment the sensor system 29 is configured to measure the position of the dies 102 sequentially during a scanning motion of the acceptor stage 27. In an alternative embodiment, the acceptor stage 27 may be configured to temporarily maintain a stationary position relative to the donor system 11 such that the sensor system 29 measures the positions of the dies 102 during standstill. By measuring during a scanning motion, the measurements may be performed more quickly.

In an embodiment the method comprises sequentially controlling each of the set of dies 102 to be closest to the acceptor surface and measuring the position of the die 102 that is closest to the acceptor surface. After all of the dies 102 have been scanned, the first die 102a can be placed. The first die 102a first needs to be moved again to its level orientation. The acceptor stage 27 is configured to move the acceptor substrate 28 to the correct position. This is shown in Figure 8, which shows the first die 102a being placed onto the acceptor substrate 28. In an embodiment the method comprises placing the dies 102 on the acceptor substrate 28 when each die is closest to the acceptor surface. When the first die 102a is being placed on the acceptor substrate 28 all other dies 102 are at a distance from the acceptor substrate 28 as a result of the non-planar property of the non-planar surface 14 of the donor substrate 11.

As shown in Figure 7, in an embodiment the donor dies 102 are arranged on the donor substrate 11 in a pattern that approximately matches the pattern in which the donor dies 102 are to be placed on the acceptor substrate 28. As a result, only small movements of the acceptor stage 29 are required going from one die to the next die. Also, only small actuations of the stage 25 of the donor system 10 are needed going from one die to the next die. An embodiment of the invention is expected to reduce the possibility of particles being undesirably generated during a bonding process. An embodiment of the invention is expected to increase throughput of a bonding process.

It is not essential to measure the positions of all of the donor dies 102 before placing any of the donor dies 102 on the acceptor substrate 28. In an alternative embodiment, only a subset of the donor dies 102 have their location measured before one of the donors dies 102 is placed on the acceptor substrate 28. By measuring only, a subset of the dies 102 before bonding the subset of dies 102, the sensitivity of the measurement by the sensor system 29 to drift may be reduced. In particular, it is possible that over time there is some drift on the stage 25 of the donor system 10, which can cause a previously made position measurement to become less accurate. An embodiment of the invention is expected to improve the accuracy of bonding.

Alternatively, all of the donor dies 102 may have their positions measured before bonding any of the donor dies 102. By measuring all of the donor dies 102 first, the amount of movement of the acceptor stage 27 may be reduced. An embodiment of the invention is expected to increase throughput of the bonding process.

In an embodiment the measurement system 23 is configured to measure the position of the stage 25 relative to the metrology frame 22 in at least 2 degrees of freedom. In particular, the measurement system 23 may be configured to measure the position of the stage 25 relative to the metrology frame 22 in the degree of freedom of the stage 25 by the actuation system 17. In an embodiment the measurement system 23 is configured to measure the position of the stage 25 relative to the metrology frame 22 in at least 3, optionally at least 4, optionally at least 5, and optionally at least 6 degrees of freedom. By measuring the stage during the stage 25 in a greater number of degrees of freedom, the position of the donor dies 102 relative to the metrology frame 22 of the bonding tool 20 may be determined more accurately.

In an embodiment the actuation system 17 is configured to actuate the donor substrate 11 in two degrees of freedom, for example rotation about the X axis and rotation about the Y axis. In an embodiment the actuation system 17 is configured to actuate the stage 25 in a third degree of freedom. For example, the actuation system 11 may be configured to actuate the stage 25 along the X axis. In an embodiment the actuation system 17 is configured to actuate the donor substrate 11 in at least 4, optionally at least 5, and optionally at least 6 degrees of freedom. By increasing the number of degrees of freedom of actuation of the donor substrate 11, the locations of the donor dies 102 may be controlled more freely. An embodiment of the invention is expected to improve isolation of the donor substrate 11 from the undesirable vibration.

As shown in Figure 8, for example, in an embodiment the acceptor substrate 28 is carrying a plurality of acceptor dies before any of the dies 102 carried by the donor substrate 11 have been placed on to the acceptor surface 28. For example, dies may have already been placed in a previous bonding process. In an embodiment the dies 102 are arranged on the donor substrate 11 in a pattern corresponding to regions of acceptor surface between the acceptor dies on the acceptor substrate 28. An embodiment of the invention is expected to increase throughput of the bonding process.

Figure 9 schematically depicts an alternative donor substrate 10. As shown in Figure 9, in an embodiment the acceptor dies that are already on the acceptor substrate 28 are thinner than the dies 102 carried by the donor substrate 11. By placing the thinnest dies first and after that dies within increasing thickness, the possibility of undesirable collision with neighbouring dies may be reduced. An embodiment of the invention is expected to improve the reliability of the bonding process.

However, it is not essential to place the thinner dies first. As shown in Figure 2, in an embodiment the donor substrate 11 comprises recesses 13. The recesses 13 may comprise grooves. The recesses 13 are between the carrier surfaces 12 of the donor substrate 11 at which the dies 102 are carried. The recesses 13 may be referred to as grooves or pockets, for example. The recesses 13 provides space which may help to reduce the possibility of collisions with dies that have already been placed on the acceptor substrate 28 in a previous phase. By providing the recesses 13, there may be greater freedom about which dies are placed first on the acceptor substrate 28. For example, it may not be necessary to place thinner dies before placing thicker dies. In an embodiment, thicker dies may be placed first on the acceptor substrate 28 with thinner dies placed later while the recesses 13 help to avoid collisions. Figure 4 schematically depicts the recesses 13 between the carrier surfaces 12. As shown in Figure 4, in an embodiment the carrier surfaces 12 may protrude at one major surface of the donor substrate 11.

In an embodiment the donor system 10 is configured to such that positions of the dies 102 relative to each other are maintained during actuation by the actuation system 17. That is, the whole of the donor substrate 11 is actuated by the actuation system 17. As the donor substrate 11 is tilted by the actuation system 17, the overall pattern of the dies 102 carried by the donor substrate 11 is maintained. It may not be necessary to actuate one of the dies 102 relative to any of the other dies 102. An embodiment of the invention is expected to simplify the actuation requirements of the donor system 10.

In an embodiment the donor substrate 11 is arranged such that the donor dies 102 are carried at a pitch of at least 1mm, optionally at least 1.1mm, optionally at least 1.2mm, optionally at least 1.5mm, optionally at least 2mm, optionally at least 3mm and optionally at least 5mm. By increasing the pitch, the possibility of undesirable collision with dies already placed on the acceptor substrate 28 may be reduced. In an embodiment, the pitch is at most 50mm, optionally at most 20mm, optionally at most 10mm, optionally at most 6mm, optionally at most 5mm, optionally at most 3mm, optionally at most 2mm and optionally at most 1.5mm. By reducing the pitch, a greater die density may be achieved. An embodiment of the invention is expected to increase throughput of a bonding process.

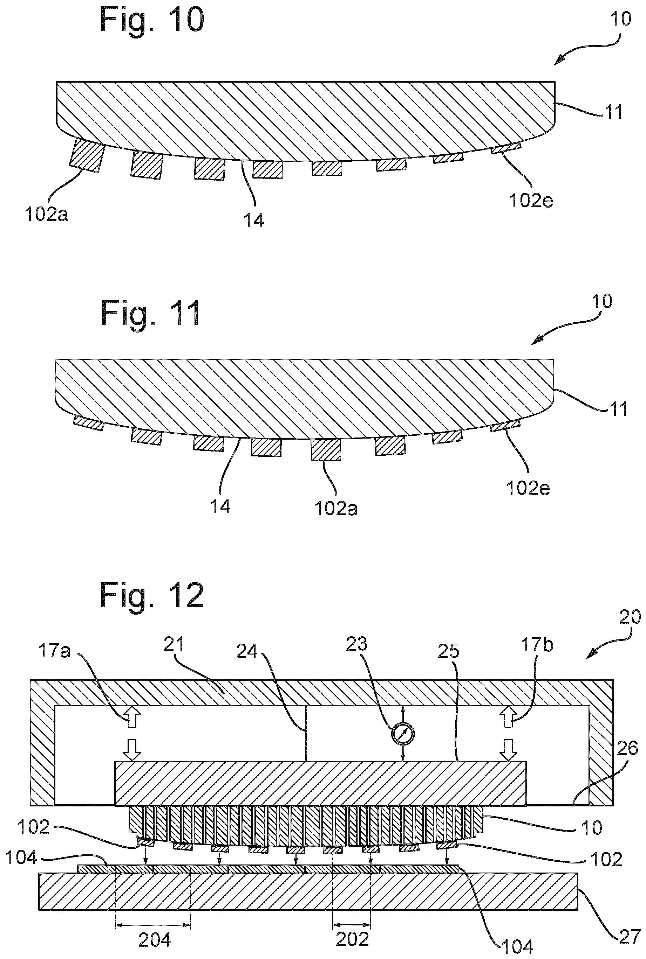

Figure 10 schematically depicts an alternative arrangement of dies 102 on a donor substrate 11. As shown in Figure 10, optionally the dies 102 may be placed on the donor substrate 11 such that the sequence of die placing starts at the thickest die and ends with the thinnest die. The first die 102a to be placed may have the largest thickness of all donor dies 102 on the donor substrate 11. The last die 102e to be placed may have the smallest thickness of all donor dies on the donor substrate 11. The neighbouring die may be always thinner than the die 102 to be placed.

Figure 11 schematically depicts an alternative arrangement in which the dies 102 are not in order of thickness on the donor substrate 11. In an embodiment the first die 102a is located at an intermediate position among the dies 102.

As shown in Figure 9, for example, in an embodiment the pitch between dies already on the acceptor substrate 28 is substantially similar to the pitch between dies 102 carried by the donor substrate 11. However, it is not essential for the acceptor die pitch to be the same as the donor die pitch. Figure 12 schematically depicts an alternative arrangement in which the acceptor die pitch 204 is different from the donor die pitch 202.

As shown in Figure 12, in an embodiment there may be a smaller die pitch on the donor side than on the acceptor side. In an alternative arrangement it is the other way round, i.e. the acceptor die pitch 204 may be smaller than the donor die pitch 202.

As shown in Figure 12, in an embodiment the donor dies 102 are to be bonded with two acceptor dies 104 carried by the acceptor stage 27.

As shown in Figure 2, for example, in an embodiment the donor system 10 comprises a pressure system 30. The pressure system 30 is configured to control pressure applied to supported surfaces of the dies 102 facing the donor substrate 11. The supported surfaces of the dies 102 are the surfaces that come into contact with the carrier surfaces 12 of the donor substrate 11.

As shown in Figure 2 or Figure 3, for example, in an embodiment the pressure system comprises a plurality of openings 31. The openings 31 are in the non-planer surface 14. For example, the openings 31 may be in the carrier surfaces 12. Each carrier surface 12 may be provided with a respective opening 31.

As shown in Figure 2, in an embodiment the pressure system 32 comprises a plurality of pressure channels 32. The pressure channels 32 are in fluid communication with the openings 31. When an overpressure is supplied to the pressure channels 32, then the pressure at the supported surfaces of the dies 102 may be increased. In an embodiment the pressure supplied to the pressure channels 32 may be controlled substantially independently of each other. For example, it can be controlled which one of the dies 102 has an overpressure applied sufficient for facilitating detachment of that die 102 from the donor substrate 11. In an embodiment the pressure system 30 is further configured to hold the dies 102 onto the donor substrate 11. For example, when an underpressure is applied to the pressure channels 32, then the dies 102 may be pneumatically clamped to the donor substrate 11.

However, it is not essential to provide a system for pneumatically clamping the dies 102 to the donor substrate 11. In an alternative embodiment, the donor substrate 11 comprises an adhesive layer configured to maintain a connection between the dies 102 and the donor substrate 11. When an overpressure is applied by the pressure system 30, then the adhesive force may be overcome so as to allow the die 102 to become detached from the donor substrate 11.

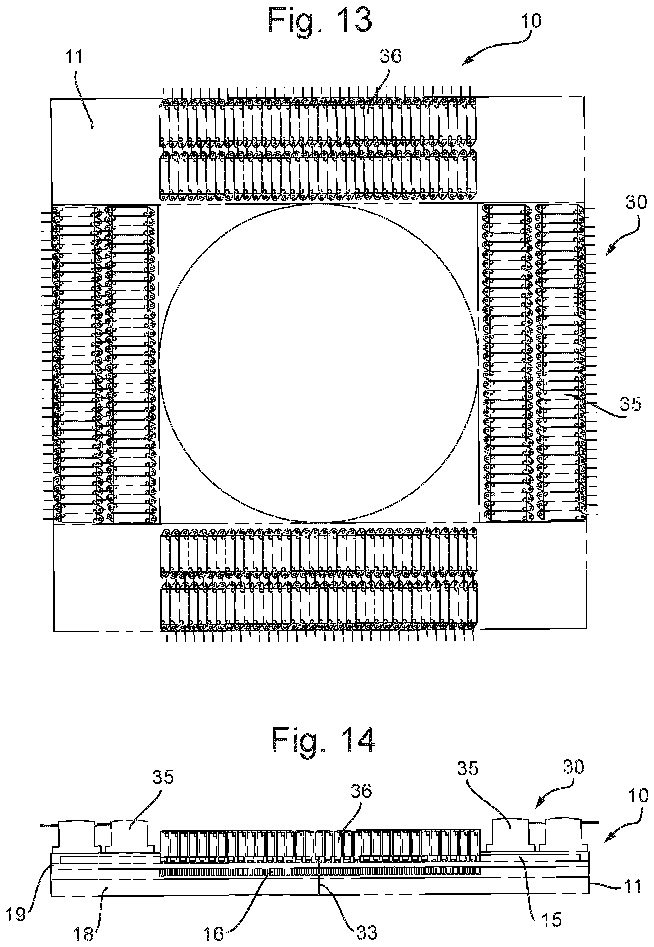

Figure 13 schematically depicts a plan view of the donor system 10. In particular, Figure 13 schematically depicts a plan view of the pressure system 30 of the donor system 10. Figure 14 schematically depicts a cross sectional view of the pressure system 30 shown in Figure 13. As shown in Figure 14, for example, in an embodiment the pressure system comprises a plurality of first grooves 15 and plurality of second grooves 16. The first grooves 15 and the second grooves 16 are provided such that the dies 102 carried by the donor substrate 11 are addressable by respective combinations of one first groove 15 and one second groove 16. That is, each carrier surface 12 of the donor substrate 11 may correspond to a unique combination of a first groove 15 and a second groove 16.

As shown in Figure 14, in an embodiment the donor substrate 11 comprises a base substrate 18, a layer of second groove 16, an intermediate layer 19 and a layer of first grooves 15. The intermediate layer 19 may be located between the first grooves 15 and the second grooves 16.

As shown in Figure 13, in an embodiment the donor system 10 comprises a plurality of first pressure regulators 35 and a plurality of second pressure regulators 36. The first pressure regulators 35 are configured to regulate pressure in respective first grooves 15. The second pressure regulators 36 are configured to regulate pressure in respect of second groove 16. The pressure regulators may be valves, for example. The first pressure regulators 35 may be substantially similar to the second pressure regulators 36, other than a controlled different set of grooves 15, 16.

As shown in Figure 13, in an embodiment the first pressure regulators 35 are arranged in arrays on opposite sides of the donor system 10, similarly, the second pressure regulators 36 may be arranged in arrays on opposite sides of the donor system 10.

By regulating pressure by one of the first pressure regulators 35 and one of the second pressure regulators 36, then one particular carrier surface may be addressed so as to facilitate one particular die 102 being detached from the donor substrate 11.

By providing the sets of grooves 15, 16, the total number of pressure regulators required in order to individually address each die 102 may be reduced. An embodiment of the invention is expected to reduce the cost of manufacturing the donor system 10. In an alternative embodiment, each carrier surface 12 and each die 102 is provided with its own pressure regulator. The pressure applied to each carrier surface 12 may be individually controllable by controlling which of the pressure regulators is activated.

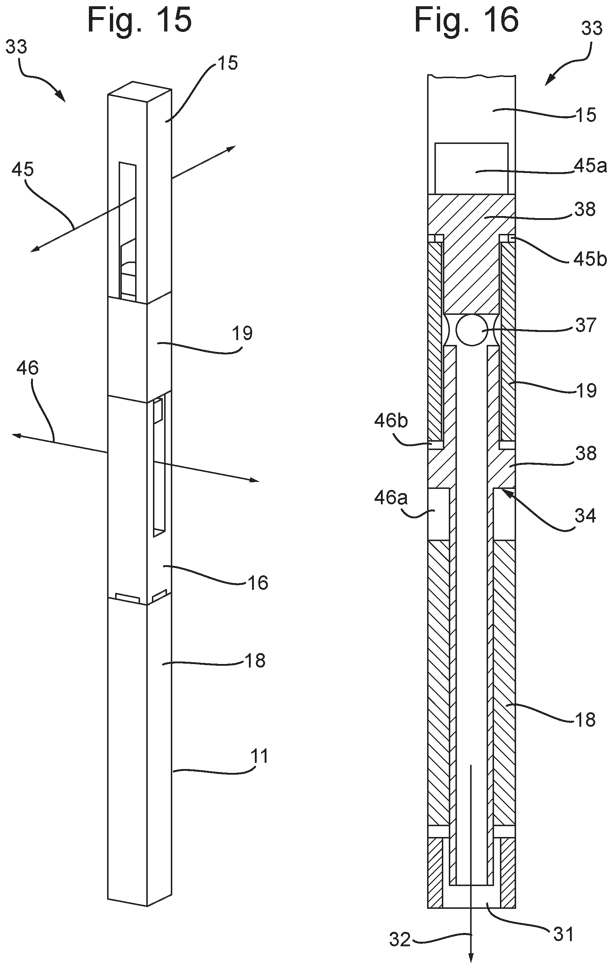

Figure 15 schematically depicts a perspective close up view of one pneumatic pixel 33 of the pressure system 30. One pneumatic pixel 33 corresponds to the arrangement of grooves that controls the pressure for one particular carrier surface 12 and one particular die 102 carried by the donor substrate 11. Figure 16 is another view of the pneumatic pixel 33 shown in Figure 5.

As shown in Figure 15, part of the first groove 15 corresponds to the pneumatic pixel 33. A first gas flow 45 may be provided through the first groove 15. Similarly, a second gas flow 46 may be provided through the second groove 16 corresponding to the pneumatic pixel 33.

Figure 16 schematically depicts a function of the pneumatic pixel 33. In an embodiment the pneumatic pixel performs a pneumatic AND function. In an embodiment the pneumatic pixel 33 is configured to activate (so as to apply an overpressure to the corresponding die 102) when an overpressure is applied through both a first groove 15 and through the second groove 16.

As shown in Figure 16, in an embodiment the pneumatic pixel 33 comprises a piston 34. The piston 34 is moveable. The piston 34 is configured to close off the channel when an overpressure is applied to only one of the first groove 15 and the second groove 16. For example, this increased pressure is applied for only the first gas flow 45 through the first groove 15, then the increased pressure in the first region 45A causes the piston 34 to move down, thereby closing off the second region 45B. Meanwhile, if an overpressure is only applied to the second groove 16, then the increased pressure in the first region 46A causes the piston 34 to move upwards, thereby closing off the second region 46B. If both the first groove 15 and the second groove 16 are pressurised, then the piston 34 may remain at an intermediate position such that the second regions 45B and 46B remain open and gas may flow through the channel 37 of the piston 34, or the piston will move up or down such that there is an open connection to one of the supply grooves. The overall pressure applied through the pressure channel 32 may be some of the pressures applied to the first groove 15 and the second groove 16.

Figure 17 schematically depicts an alternative arrangement for the pressure system 30. As shown in Figure 17, the pitch of the dies 102 can be any number, so long as it is larger than the pitch of the pneumatic pixels 33 of the pressure system 30. As shown in Figure 17, in an embodiment the pressure channels 32 are angled relative to the x-y plane.

Figure 18 schematically depicts an alternative arrangement in which each carrier surface 12 and die 102 is provided with a plurality of pressure channels 32. In an embodiment a plurality of pneumatic pixels 32 may be activated simultaneously. An embodiment of the invention is expected to increase the maximum pressure that can be applied to the backside of each donor die 102. An embodiment of the invention is expected to reduce switching times.

Figure 19 schematically depicts an alternative donor system 10, the donor system 10 comprises a donor substrate 11 configured to carry the donor dies 102. As shown in Figure 19, in an embodiment the donor dies 102 may be arranged in a substantially planer orientation relative to each other. This is different from the arrangement in Figure 2, for example. Where the donor dies 102 are arranged at a non-planer surface.

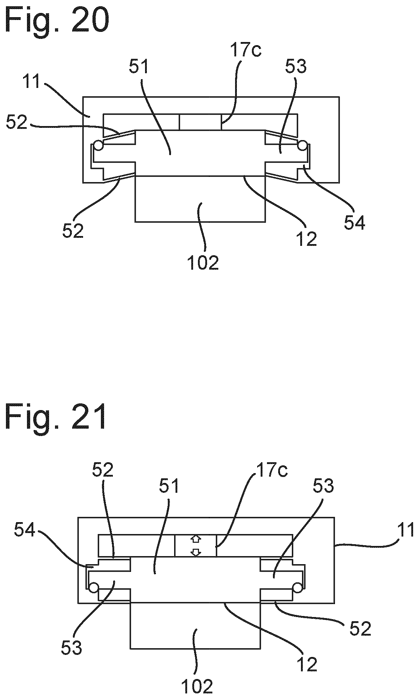

As shown in Figure 19, in an embodiment the actuation system 17 of the donor system 10 is configured to selectively actuate the dies 102 independently of each other perpendicularly to the acceptor surface of the acceptor substrate 28. In the orientation shown in Figure 19, the actuation system 19 is configured to independently actuate each donor die 102 downwards. The actuation system is described in more detail with reference to Figure 20 and Figure 21.

Figure 20 schematically depicts a close up view of an individual actuator 17c of the actuation system 17 of the donor system 10. Figure 20 schematically shows the die 102 in an up state corresponding to an up state of the individual actuator 17c. Figure 21 schematically depicts the individual actuator 17c in a down state such that the die 102 is in the down state.

As shown in Figure 20, in an embodiment the individual actuator 17c is configured to actuate the donor die 102 between the up state shown in Figure 20 and the down state shown in Figure 21. In an embodiment the actuation system 17 comprises a vertically moving body 51. The vertically moving body 51 may comprise the carrier surface 12 on which the donor die 102 is mounted. The individual actuator 17c may comprise a piezoelectric element. Alternatively, the individual actuator 17c may comprise a pneumatic actuator. The individual actuator 17c is configured to actuate the vertically moving body 51.

As shown in Figure 20, in an embodiment the donor substrate 11 comprises grooves 54, configured to accommodate a flange 53 of the vertically moving body 51. The flange 53 is configured to abut against surfaces of the donor substrate 11 so as to prevent the vertically moving body 51 from becoming completely detached from the donor substrate 11.

In the arrangement shown in Figure 20, the flange 53 comes into contact with the donor substrate 11 at a contact point 53. The contact point 53 is at the upper edge of the flange 53, thereby limiting the stroke of the vertically moving body 51 relative to the rest of the donor substrate 11. In the arrangement shown in Figure 21, the contact point 53 is at the opposite side of the flange, thereby limiting the stroke of the vertically moving body 51.

As shown in Figure 20, in an embodiment the donor system 10 comprises at least one guide 52. In an embodiment the donor system 10 comprises a plurality of guides 52. The guides 52 are configured to guide actuation of respective dies 102 perpendicularly to the acceptor surface. In an embodiment the guides 53 comprises parallel leaf spring guides. An embodiment of the invention is expected to improve the accuracy of a bonding process.

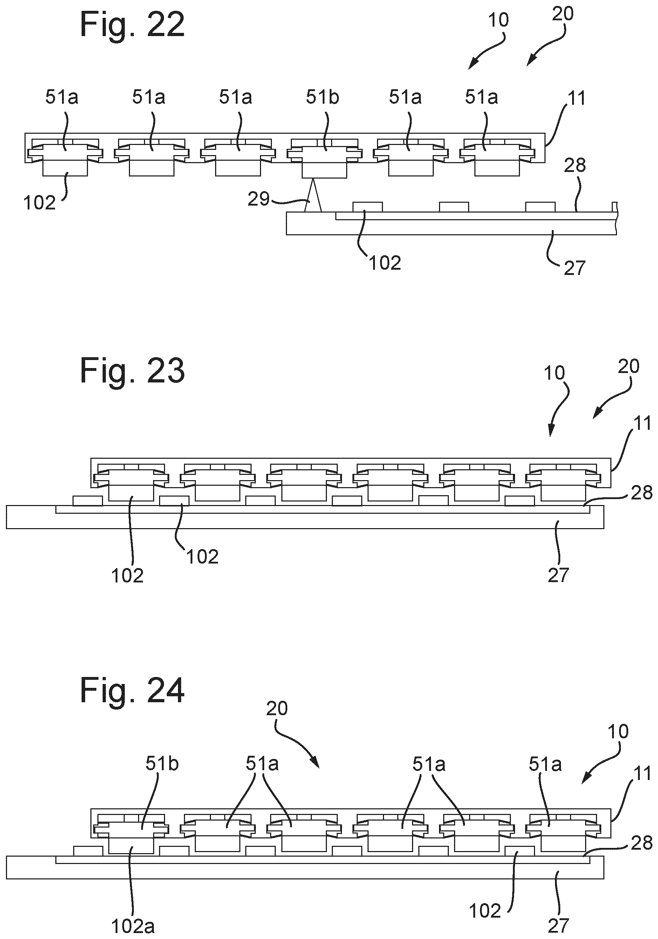

Figure 19 schematically depicts all of the dies 102 in the up state. As shown in Figure 22, one of the dies 102 may be actuated to the down states. The down state corresponds to the state in which the die 102 may be later bonded to the acceptor substrate 28.

As shown in Figure 22, the position of the die 102 may be measured when the die 102 is in the down state. The positions of the dies 102 may be measured with respect to the acceptor stage 27. The sensor system 29 is integrated into the acceptor stage 27 in order to measure the positions of the dies 102.

The sensor system 29 may comprise an alignment sensor configured to determine the position of the dies 102 by the marks on the dies 102.

After measuring a die 102, the individual actuator 17c may be configured to actuate the die 102 to the up state. The next die 102 can then be measured with the actuator 17c for that die 102 actuating it to the down state. Once all dies 102 have been measured, then those dies 102 are actuated to the up state.

As shown in Figure 23, the acceptor stage 27 may be configured to actuate the acceptor substrate 28 to be close to the dies 102 on the donor system 10. As shown in Figure 23, in an embodiment the arrangement of dies 102 on the donor substrate 11 is similar to the arrangement in which the dies 102 are to be bonded onto the acceptor substrate 28.

As shown in Figure 24, one of the donor dies 102 may be switched to the down state. For example, Figure 24 shows the first donor die 102a to be bonded in the down state. Accordingly, the vertically moving bodies 51a of the other individual actuators 17c are in the in the up state, while than the vertically moving body of 51b of the first donor die 102a is in the down state.

The acceptor stage 27 is configured to move upwards to initiate the bond process. The first donor die 102a can be released from the donor substrate 11, for example by means of a pneumatic pressure pulse by a pressure system 30, for example.

The amount of movement required by the acceptor stage 27 may be relatively low going from one die to the next. An embodiment of the invention is expected to increase throughput.

In an embodiment a maximum actuation stroke of the actuation system 17 perpendicular to the acceptor surface or perpendicular to the donor substrate is less than the thickness of the dies 102. By requiring only small actuation in the z-axis accuracy of the bonding process may be improved by requiring smaller actuation, the possibility of particles being undesirably generated may be reduced. An embodiment of the invention is expected to improve the reliability of the bonding process.

However, it is not essential for the maximum actuation stroke of the actuation system 17 to be less than the thickness of the dies 102. In an alternative embodiment, the maximum actuation stroke is greater than the thickness of the dies 102. An embodiment of the invention is expected to reduce the possibility of undesirable collision between adjacent dies on the donor substrate and any dies on the acceptor substrate 28. In an alternative embodiment, the acceptor substrate 28 may be located directly above the donor substrate 11, with the acceptor surface facing downwards towards the donor substrate 11. Other aspects of the invention are set-out as in the following numbered clauses.
1. A donor system for a bonding tool, the donor system comprising:
   a donor substrate configured to carry a plurality of dies; and
   an actuation system configured to sequentially control the plurality of dies, while being carried by the donor substrate, to be closest to an acceptor surface of an acceptor substrate.
2. The donor system of clause 1, wherein the donor substrate is configured to carry the dies on a nonplanar surface.
3. The donor system of clause 2, wherein the nonplanar surface is curved.
4. The donor system of clause 3, wherein the nonplanar surface is a substantially spherical sector.
5. The donor system of any preceding clause, wherein the actuation system is configured to rotate the donor substrate about at least one axis perpendicular to a bonding direction.
6. The donor system of clause 5, wherein the actuation system is configured to rotate the donor substrate about two nonparallel axes perpendicular to the bonding direction.
7. The donor system of any preceding clause, wherein the donor substrate is configured to carry the dies at respective carrier surfaces of the donor substrate, wherein the carrier surfaces are convex.
8. The donor system of any preceding clause, wherein the donor substrate comprises:
   recesses between carrier surfaces of the donor substrate at which the dies are carried.
9. The donor system of any preceding clause, comprising:
   a pressure system configured to control pressure applied to surfaces of the dies facing the donor substrate.
10. The donor system of clause 9, wherein the pressure system comprises:
   a plurality of first grooves and a plurality of second grooves such that the dies carried by the donor substrate are addressable by respective combinations of one first groove and one second groove;
   a plurality of first pressure regulators configured to regulate pressure in respective first grooves; and
   a plurality of second pressure regulators configured to regulate pressure in respective second grooves.
11. The donor system of any preceding clause, configured such that positions of the dies relative to each other are maintained during actuation by the actuation system.
12. The donor system of any of clauses 1-10, wherein the actuation system is configured to selectively actuate the dies independently of each other perpendicularly to the acceptor surface.
13. The donor system of clause 12, wherein a maximum actuation stroke of the actuation system perpendicular to the acceptor surface or perpendicular to the donor substrate is less than a thickness of the dies.
14. The donor system of clause 12 or 13, comprising:
   a plurality of guides configured to guide actuation of respective dies perpendicularly to the acceptor surface.
15. A bonding tool comprising:
   the donor system of any preceding clause.
16. The bonding tool of clause 15, comprising:
   a sensor system configured to measure positions of the dies carried by the donor substrate relative to the acceptor surface.
17. The bonding tool of clause 16, comprising:
   an acceptor stage configured to position the acceptor substrate relative to a frame of the bonding tool, wherein the sensor system is at least partially mounted on the acceptor stage.
18. A method for moving dies relative to an acceptor substrate within a bonding tool, the method comprising:
   carrying a plurality of dies with a donor substrate; and
   actuating the donor substrate or a carrier surface on the donor substrate so as to sequentially control which of the plurality of dies is closest to an acceptor surface of the acceptor substrate.
19. The method of clause 18, comprising:
   carrying the dies with the donor substrate in away that different dies are differently distanced from the acceptor surface.
20. The method of clause 18 or 19, comprising:
   attaching the dies to the donor substrate outside of the bonding tool.
21. The method of any of clauses 18-20, comprising:
   measuring positions of a set of the dies carried by the donor substrate relative to the acceptor surface.
22. The method of clause 21, wherein the measuring comprises sequentially controlling each of the set of dies to be closest to the acceptor surface, and measuring the position of the die that is closest to the acceptor surface.
23. The method of any of clauses 18-22, comprising:
   placing the dies on the acceptor substrate when each die is closest to the acceptor surface.
24. The method of clause 23, wherein the acceptor substrate is carrying a plurality of acceptor dies before any of the dies carried by the donor substrate have been placed onto the acceptor surface.
25. The method of clause 24, wherein the dies are arranged on the donor substrate in a pattern corresponding to regions of the acceptor surface between the acceptor dies.
26. The method of clause 24 or 25, wherein the acceptor dies are thinner than the dies carried by the donor substrate.
27. The method of any of clauses 18-26, wherein the dies carried by the donor substrate are of different thicknesses, and the dies are placed on the acceptor surface in decreasing order of thickness.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A donor system for a bonding tool, the donor system comprising:
a donor substrate configured to carry a plurality of dies; and
an actuation system configured to sequentially control the plurality of dies, while being carried by the donor substrate, to be closest to an acceptor surface of an acceptor substrate.

2. The donor system of claim 1, wherein the donor substrate is configured to carry the dies on a nonplanar surface.

3. The donor system of any preceding claim, wherein the actuation system is configured to rotate the donor substrate about at least one axis perpendicular to a bonding direction.

4. The donor system of any preceding claim, wherein the donor substrate is configured to carry the dies at respective carrier surfaces of the donor substrate, wherein the carrier surfaces are convex.

5. The donor system of claim 4, wherein the donor substrate comprises:
recesses between carrier surfaces of the donor substrate at which the dies are carried.

6. The donor system of any preceding claim, comprising:
a pressure system configured to control pressure applied to surfaces of the dies facing the donor substrate.

7. The donor system of any preceding claim, configured such that positions of the dies relative to each other are maintained during actuation by the actuation system.

8. The donor system of any of claims 1-6, wherein the actuation system is configured to selectively actuate the dies independently of each other perpendicularly to the donor substrate.

9. A bonding tool comprising:
the donor system of any preceding claim.

10. The bonding tool of claim 9, comprising:
a sensor system configured to measure positions of the dies carried by the donor substrate relative to the acceptor surface.

11. A method for moving dies relative to an acceptor substrate within a bonding tool, the method comprising:
carrying a plurality of dies with a donor substrate; and
actuating the donor substrate or a carrier surface on the donor substrate so as to sequentially control which of the plurality of dies is closest to an acceptor surface of the acceptor substrate.

12. The method of claim 11, comprising:
carrying the dies with the donor substrate in a way that different dies are differently distanced from the acceptor surface.

13. The method of claim 11 or 12, comprising:
measuring positions of a set of the dies carried by the donor substrate relative to the acceptor surface.

14. The method of any of claims 11-13, comprising:
placing the dies on the acceptor substrate when each die is closest to the acceptor surface.

15. The method of any of claims 11-14, wherein the dies carried by the donor substrate are of different thicknesses, and the dies are placed on the acceptor surface in decreasing order of thickness.
